Europäisches Patentamt

European Patent Office

Office européen des brevets

(11) Veröffentlichungsnummer: **0 194 569**
**B1**

(12) **EUROPÄISCHE PATENTSCHRIFT**

(45) Veröffentlichungstag der Patentschrift:
26.07.89

(51) Int. Cl.⁴: **H01L 29/40, H01L 21/285**

(21) Anmeldenummer: **86102891.8**

(22) Anmeldetag: **05.03.86**

(54) Dünnfilmschichtaufbau mit einer reaktiven Zwischenschicht für integrierte Halbleiterschaltungen.

(30) Priorität: **13.03.85 DE 3509001**

(43) Veröffentlichungstag der Anmeldung:
**17.09.86 Patentblatt 86/38**

(45) Bekanntmachung des Hinweises auf die Patenterteilung:
**26.07.89 Patentblatt 89/30**

(84) Benannte Vertragsstaaten:
**AT BE DE FR GB IT NL**

(56) Entgegenhaltungen:
EP-A- 0 000 743
GB-A- 1 229 355
US-A- 2 957 112

EXTENDED ABSTRACTS, Band 81-8, Nr. 306, Mai 1981,
Seiten 765-767, Pennington, US; C.Y. TING et al.: "Al/Ti
contact Metallurgy for VLSI applications: Part I.
Electrical Properties"

(73) Patentinhaber: **Siemens Aktiengesellschaft Berlin und München, Wittelsbacherplatz 2, D-8000 München 2(DE)**

(72) Erfinder: **Griessing, Jürgen, Dipl.-Phys., Schlehdornweg 6, D-8011 Baldham(DE)**
Erfinder: **Reindl, Werner, Kirchfeldstrasse 6, D-8025 Unterhaching(DE)**

## Beschreibung

Die Erfindung bezieht sich auf einen Dünnfilmschichtaufbau zur Herstellung von integrierten Halbleiterschaltungen bestehend aus einer Siliziumunterlage und einer leitenden Schicht aus dem Silizid eines hochschmelzenden Metalls (z.B. Ta, Ti, Mo, W), wobei der Schichtaufbau im weiteren Prozeßablauf getempert und gegebenenfalls oxidiert wird.

In der Herstellung von integrierten Halbleiterschaltungen wird vielfach eine Schichtkombination aus Silizium und dem Silizid eines hochschmelzenden Metalls verwendet. Im weiteren Prozeßablauf wird diese Schichtkombination getempert und häufig auch oxidiert. Dabei besteht das Problem, daß bereits eine aus wenigen Atomlagen bestehende Schicht aus Fremdmaterial, beispielsweise Oxid, Nitrid oder Carbid, das sich vor der Silizidabscheidung auf der Oberfläche der Unterlage gebildet hat, die Siliziumdiffusion behindert oder unmöglich macht bzw. den Übergangswiderstand erhöht.

Eine Oxidlage auf dem Silizium wird in der Regel durch eine naßchemische Überätzung, sogenannte "HF-Dip", vor der Silizidabscheidung entfernt. Außerdem wird vielfach unmittelbar vor der Silizidabscheidung das Substrat unter Vakuum einem Ionenbombardement ausgesetzt, wodurch die Oberfläche durch Abtrag gereinigt wird.

Bei dem ersten Verfahren wirkt sich nachteilig aus, daß nur eine Oxidlage entfernt werden kann und außerdem wegen der Gefahr der Rückbildung des Oxids an der Luft die Scheiben innerhalb weniger Minuten mit Silizid beschichtet werden müssen. Beim zweiten Verfahren ist nachteilig, daß Schädigungen des Halbleitermaterials nicht ausgeschlossen werden können.

Der Erfindung liegt die Aufgabe zugrunde, die entstandene Schicht aus Fremdmaterial aufzulösen bzw. in unschädliche Verbindungen umzuwandeln. Dies geschieht dadurch, daß zwischen der Siliziumunterlage und der leitenden Schicht eine reaktive Zwischenschicht vorgesehen ist. Dadurch wird auch ein besonders guter Kontakt zwischen der Siliziumschicht und der darüber liegenden Schicht erzeugt.

Eine Wirkung von Titanschichten als Getter- und Reduktionsmittel auf Silizium ist für Al/Ti-Kontaktmetallisierungen aus Extended Abstracts, Band 81-8, Nr. 306, Mai 1981, S. 765–767 bekannt.

Die Reaktionsenthalpien der genannten Metalle (Ta, Ti, Mo, W) mit Sauerstoff, Stickstoff und Kohlenstoff sind höher als die von Silizium, das heißt, daß die entsprechenden Si-Verbindungen unter Bildung von Metall-Oxid, -Nitrid und -Carbid gelöst werden können.

Nach einer Weiterbildung der Erfindung wird als reaktive Zwischenschicht eine sehr dünne, zum Beispiel 10 nm, Lage desselben Metalls das zur Silizidbildung verwendet wird, eingelagert. Das hat besondere Vorteile bei der Abscheidung und Weiterverarbeitung (Ätzen).

Die Erfindung wird anhand der Figuren erläutert. Es zeigen:

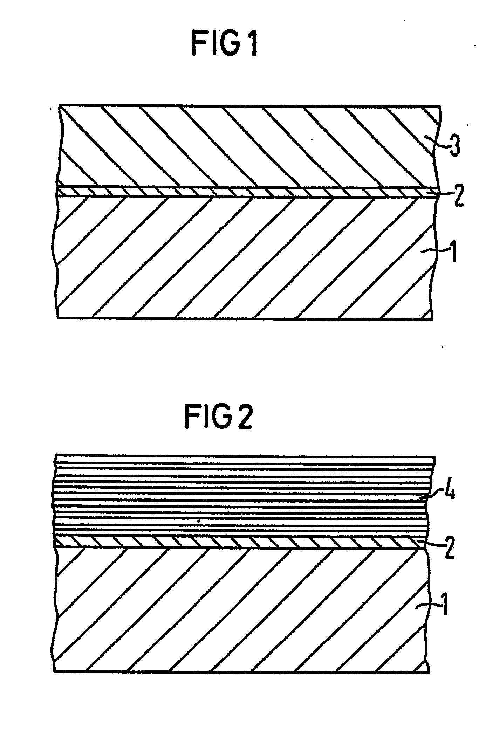

Figur 1 einen Schnitt durch einen homogenen Dünnfilmschichtaufbau und

Figur 2 einen Schnitt durch eine Mehrfachschichtabscheidung.

In den Figuren ist jeweils mit 1 Silizium, mit 2 eine reaktive Zwischenschicht, mit 3 eine homogene Silizidschicht und mit 4 eine Mehrfachschichtabscheidung, zum Beispiel aus Tantal und Silizium, angedeutet.

Diese Schichten werden hintereinander im Vakuum abgeschieden. Das erfindungsgemäße Verfahren setzt keinesfalls plane Oberflächen voraus, sondern ist mit demselben Erfolg auch bei teilweise offenliegenden Siliziumschichten anwendbar.

## Patentansprüche

1. Dünnfilmschichtaufbau zur Herstellung von integrierte Halbleiterschaltungen bestehend aus einer Siliziumunterlage (1) und einer leitenden Schicht (3, 4) aus dem Silizid eines hochschmelzenden Metalls (z.B. Ta, Ti, Mo, W), wobei der Schichtaufbau im weiteren Prozeßablauf getempert und gegebenenfalls oxidiert wird, **dadurch gekennzeichnet**, daß zwischen der Siliziumunterlage (1) und der leitenden Schicht (3, 4) eine reaktive Zwischenschicht (2) vorgesehen ist, die während der Temperung Oberflächenverunreinigungen auf der Siliziumunterlage (1) auflöst und in unschädliche Verbindungen umwandelt.

2. Dünnfilmschichtaufbau nach Anspruch 1, **dadurch gekennzeichnet**, daß als reaktive Zwischenschicht (2) eine sehr dünne, zum Beispiel 10 nm dicke Lage desselben Metalls, das zur Silizidbildung verwendet wird, zum Beispiel Ta, eingelagert ist.

## Claims

1. Thin-film layer structure for the production of integrated semiconductor circuits consisting of a silicon base (1) and a conductive layer (3, 4) of the silicide of a refractory metal (for example Ta, Ti, Mo, W), the layer structure being tempered and possibly oxidized during the further process sequence, characterized in that there is provided between the silicon base (1) and the conductive layer (3, 4) a reactive intermediate layer (2) which dissolves surface impurities on the silicon base (1) during tempering and converts them into harmless compounds.

2. Thin-film layer structure according to Claim 1, characterized in that a very thin, for example 10 nm thick layer of the same metal which is used for silicon formation, for example Ta, is incorporated as reactive intermediate layer (2).

## Revendications

1. Structure de couches de type à couche mince pour la fabrication de circuits intégrés à semi-conducteurs, constituée d'un substrat de silicium (1) et d'une couche conductrice (3, 4) formée du siliciure d'un métal à haut point de fusion (Ta, Ti, Mo, W par exemple), structure qui est soumise, lors de la suite du processus, à un recuit et, éventuellement, une oxydation, caractérisée par la prévision, entre le substrat de silicium (1) et la couche conductrice (3, 4), d'une couche intermédiaire réactive (2) qui dissout des impuretés superficielles sur le substrat de silicium (1) pendant le recuit et les transforme en composés qui ne sont pas nuisibles.

2. Structure selon la revendication 1, caractérisée en ce que la couche intermédiaire réactive (2) incorporée est une couche très mince, de 10 nm par exemple, du même métal, Ta par exemple, que celui utilisé pour la formation du siliciure.

# FIG 1

# FIG 2